# EUROPEAN PATENT SPECIFICATION

(11) **EP 4 470 966 B1**
(45) Date of publication and mention of the grant of the patent: **19.11.2025**
(21) Application number: 24178428.9
(22) Date of filing: 28.05.2024
(51) Int. Cl.: B81B 3/00

(54) **LOCKING SYSTEM OF A MICROMECHANICAL ELEMENT AND METHOD OF LOCKING A MICROMECHANICAL ELEMENT**
VERRIEGELUNGSSYSTEM EINES MIKROMECHANISCHEN ELEMENTES UND VERFAHREN ZUR VERRIEGELUNG EINES MIKROMECHANISCHEN ELEMENTES
SYSTÈME DE VERROUILLAGE D'UN ÉLÉMENT MICROMÉCANIQUE ET MÉTHODE DE VERROUILLAGE D'UN ÉLÉMENT

(30) Priority: 30.05.2023 IT 202300010911
(43) Date of publication of application: 04.12.2024
(73) Proprietor: Fondazione Bruno Kessler, 38122 Trento (IT)
(72) Inventor: BAGOLINI, Alvise, 38121 TRENTO (IT)
(74) Representative: Marchioro, Paolo

(56) References cited:
- US-B1- 6 170 332
- US-B1- 6 682 059
- US-B2- 8 656 837

## Description

The invention relates to a clamping system of a micromechanical element defined on a support surface of a plate made of a semiconductor material.

The invention also relates to a method for clamping a micromechanical element using such a clamping system.

A micromechanical device comprising at least one micromechanical element clamped in position by means of the aforementioned clamping system and the associated clamping method is also part of the invention.

The invention also relates to an inertial device comprising at least one of these micromechanical devices.

It is important to emphasise that the terms "micromechanical element" and "micromechanical device" refer respectively to an element and a device whose dimensions are microscopic, i.e. lower than 1 mm.

Systems are known nowadays for clamping a micromechanical element defined on a support surface of a plate made of a semiconductor material.

Such a known-type clamping system comprises a pair of guide elements projecting stably from that support surface.

These guide elements are arranged parallel and symmetrically to a translation axis and are aligned and spaced along an axis orthogonal to this translation axis.

In particular, these guide elements are configured to act as a sliding guide for the micromechanical element when this micromechanical element is moved between them along the translation axis.

Still more precisely, the coupling surfaces of the micromechanical element and the aforementioned guide elements have rack profiles with inclined teeth configured to be coupled together so as to allow the translation of the micromechanical element in one sliding direction and prevent it from sliding in the opposite direction along the aforementioned translation axis.

However, a similar clamping system, although known and appreciated, has some important limitations.

In particular, once the desired clamping position of the micromechanical element between the guide elements has been reached, this micromechanical element is clamped in one sliding direction, but is still unfavourably free to translate in the opposite sliding direction along the aforementioned translation axis.

A second limitation of such a known-type clamping system is related to the low clamping resolution along the translation axis of the aforementioned micromechanical element, which is disadvantageously linked to the pitch defined between the teeth of the racks used for clamping the micromechanical element. US 8 656 837 B2 discloses a clamping system of a micromechanical element defined on a support surface of a plate made of silicon. Said system comprises at least one abutment element projecting stably from said support surface and configured to act as an end-stop for said micromechanical element in a clamping position when said micromechanical element is moved along a translation axis towards said abutment element, a pair of fulcrum elements projecting stably from said support surface, said fulcrum elements being arranged symmetrically with respect to said translation axis and being spaced along an axis orthogonal to said translation axis.

The task of the present invention is to develop a clamping system capable of obviating the aforementioned drawbacks and limitations of the prior art.

In particular, it is the object of the present invention to manufacture a clamping system that allows to clamp any movement of a micromechanical element on a support surface of a plate made of a semiconductor material once the desired clamping position has been reached.

It is also an object of the invention to develop a clamping system that allows to obtain a higher clamping resolution of a micromechanical element along a translation axis if compared to similar known-type clamping systems. The invention is set out in the appended set of claims.

The above-mentioned task and objects are achieved by a clamping system according to claim 1.

Further features of the clamping system according to claim 1 are described in the dependent claims.

The task and the aforesaid objects, together with the advantages that will be mentioned hereinafter, are indicated by the description of an embodiment of the invention, which is given by way of non-limiting example with reference to the attached drawings, where:
- Figure 1 represents a schematic plan view of a first embodiment of a clamping system according to the invention in a first operating configuration;
- Figure 2 represents a schematic plan view of the clamping system of Figure 1 in a second operating configuration;
- Figure 3 represents a schematic plan view of the clamping system of Figure 1 in a third operating configuration;
- Figure 4 represents a schematic plan view of a second embodiment of a clamping system according to the invention in a first operating configuration;
- Figure 5 represents a schematic plan view of the clamping system of Figure 4 in a second operating configuration;
- Figure 6 represents a schematic plan view of the clamping system of Figure 4 in a third operating configuration.

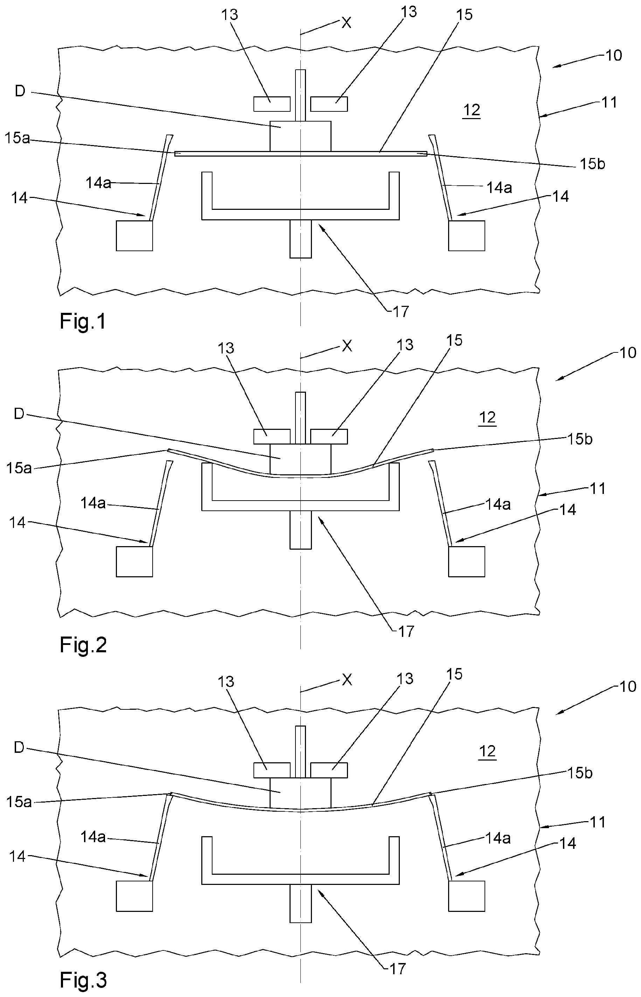

With reference to the above-mentioned figures, a clamping system according to a first embodiment of the invention is globally indicated with number **10** and is clearly visible in Figures 1, 2 and 3.

Specifically, such a clamping system **10** is adapted to clamp a micromechanical element D defined on a support surface **12** of a plate **11** made of a semiconductor material.

More precisely, Figure 1 shows a first operating configuration of the clamping system **10** with the micromechanical element D free to translate along a translation axis X on the support surface **12,** Figure 2 shows a second operating configuration of the clamping system **10** with the micromechanical element **D** during the clamping procedure, while Figure 3 shows a third operating configuration of the clamping system **10** with the micromechanical element **D** clamped in the clamping position.

This clamping system **10** comprises:
- a pair of abutment elements **13,** clearly visible in Figures 1, 2 and 3, projecting stably from the support surface **12** and configured to act as an end-stop for the micromechanical element **D** in a clamping position when said micromechanical element **D** is moved along said translation axis **X** towards the abutment elements **13;**
- a pair of fulcrum elements **14** projecting stably from the support surface **12,** clearly visible in Figures 1, 2 and 3, where these fulcrum elements **14** are arranged symmetrically with respect to the translation axis **X** and spaced along an axis orthogonal to the translation axis **X;**
- a flexible rod **15** free to translate along the translation axis **X** on the support surface **12** and whose length at rest is greater than the minimum distance between the fulcrum elements **14;** more specifically, said flexible rod **15** is configured to be placed and maintained bent between the pair of fulcrum elements **14** and the micromechanical element **D** so as to clamp said micromechanical element **D** when the latter is placed in the clamping position along the translation axis **X** against the abutment element **13.**

It can be seen that the movement of the micromechanical element **D** coincides with the aforementioned clamping procedure schematised in Figure 2, while the micromechanical element **D** reaches the end-stop along the translation axis **X** and against the abutment elements **13** exactly in the clamping position, as shown in Figure 3.

It should also be noted that the abutment elements **13,** the fulcrum elements **14** and the flexible rod **15,** as well as possibly the micromechanical element **D,** are made on the support surface **12** of the plate **11** made of a semiconductor material by a material removing process commonly referred to as etching.

It is well known that the limitation of this technique for removing material from a plate made of a semiconductor material is related to the high minimum distance between the elements that can be obtained by this procedure.

Therefore, for specific technical applications where a lower minimum distance between the aforesaid elements is required, and to which the use of the present invention is directed, the movement and clamping of micromechanical elements on a support surface of a plate made of a semiconductor material as a result of the aforesaid etching process appear to be necessary.

In particular, as inferable from what has been described above, the clamping system **10** allows to clamp any movement of the micromechanical element **D** on the support surface **12** of the plate **11** once the desired clamping position has been reached.

Furthermore, the clamping resolution of the micromechanical element **D** along the translation axis **X** only depends on the tolerances of the etching process in the creation of the abutment elements **13,** and therefore it is clearly better than the clamping resolution obtained by means of known-type clamping systems.

It is also important to emphasise that each element of the aforementioned pair of fulcrum elements **14** comprises a guide rod **14a,** where these guide rods **14a** extend in directions incident to each other in the clamping direction of the micromechanical element **D.**

This advantageously allows to obtain a gradual bending of the flexible rod **15** during the clamping procedure of the micromechanical element **D,** i.e. during the translation of the micromechanical element **D** along the translation axis X until the pair of fulcrum elements **14** is passed by said flexible rod **15.**

In the present embodiment of the invention, each guide rod **14a** has a concavity at the end adapted to maintain the flexible rod **15** bent when the micromechanical element **D** is arranged in the clamping position.

Furthermore, the ends **15a** and **15b** of the flexible rod **15** have a convexity configured to be coupled to the aforementioned concavity of the guide rod **14a** so as to prevent spurious movements of the flexible rod **15** when the micromechanical element **D** is arranged in the clamping position.

However, it cannot be ruled out that this concavity of each guide rod **14a** and this convexity of the ends **15a** and **15b** are not present or that the point of engagement defined between each guide rod **14a** and the flexible rod **15** is different than previously described.

It is also noted that this flexible rod **15** is attached to the micromechanical element **D,** but it cannot be ruled out that this flexible rod **15** and the aforementioned micromechanical element **D** are separated from each other.

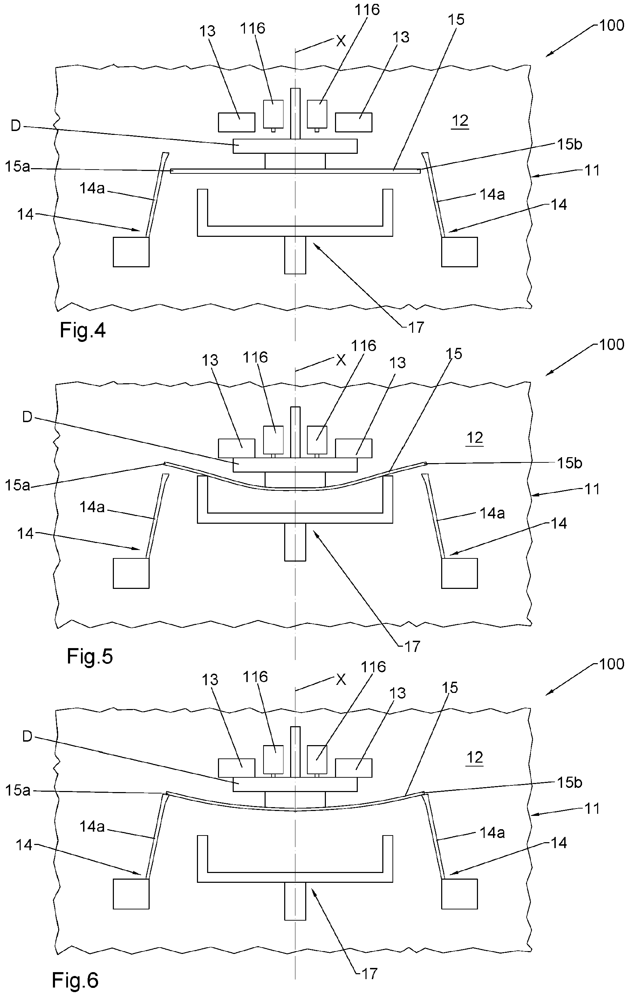

In a second embodiment of the invention, an alternative clamping system, globally indicated by number **100** and clearly visible in Figures 4, 5 and 6, is configured similarly to the clamping system **10** just described.

This clamping system **100** additionally comprises a pair of anchoring elements **116,** also visible in Figures 4, 5 and 6, projecting stably from said support surface **12** and configured to mechanically engage with the micromechanical element **D** in the aforesaid clamping position when said micromechanical element **D** is moved along the translation axis **X.**

In particular, these anchoring elements **116** are configured to be welded with the micromechanical element **D** when this micromechanical element **D** is arranged in a clamping position along the translation axis **X** against the abutment elements **13** and against the aforesaid anchoring elements **116.**

In the present embodiment of the invention, the anchoring elements **116** are made of a semiconductor material doped in such a way as to be conductive and promote resistance welding.

This means that, by applying an electrical voltage between the anchoring elements **116** and the micromechanical element **D** to be fixed, a melting of the material is generated at their point of contact.

This advantageously allows to reinforce the clamping of the micromechanical element **D** when it is arranged in the clamping position.

As mentioned above, the invention also relates to a method for clamping a micromechanical element using such a clamping system.

With particular reference to the clamping system **10** according to the first embodiment of the invention, this clamping method comprises the following sequential steps:
a) arranging the flexible rod **15** at rest along the translation axis **X** between the fulcrum elements **14** and orthogonally to the translation axis **X;**
b) arranging the micromechanical element **D** on the support surface **12** along the translation axis **X** between the abutment elements **13** and the flexible rod **15** by orienting this micromechanical element **D** to the desired clamping position;
c) translating the ends **15a** and **15b** of the flexible rod **15,** clearly shown in Figures 1, 2 and 3, at the same time as the micromechanical element **D** by actuating means **17** along the translation axis X until the pair of fulcrum elements **14** is passed and until said micromechanical element D is brought to rest on the abutment element **13;**
d) stopping the translation of the ends **15a** and **15b** of the flexible rod **15** by retracting the actuating means **17** so that the flexible rod **15,** bent, rests at the ends **15a** and **15b** on the pair of fulcrum elements **14** pushing the micromechanical element **D** into the clamping position along the translation axis **X** and against the abutment elements **13.**

With reference to the clamping system **100** according to the second embodiment of the invention, an alternative clamping method according to the invention comprises the steps a), b), c) and d) described above and a further step reported hereinafter:
e) applying an electrical voltage between the anchoring elements **116** and the micromechanical element **D** after step d) so as to weld the anchoring elements **116** to the micromechanical element **D.**

A micromechanical device comprising at least one micromechanical element which is clamped in position by one of the above-mentioned clamping methods is also part of the present invention.

For example, in an embodiment of the invention, the micromechanical device consists of a variable capacitor of a MEMS system, while the micromechanical element clamped in position by one of the clamping methods described above is one of the armatures of that variable capacitor.

Furthermore, as noted above, the invention also relates to an inertial device comprising at least one of these micromechanical devices.

For example, in the present embodiment of the invention, the inertial device is an accelerometer comprising the aforementioned variable capacitor.

In practise, it has been established that the invention achieves the intended task and objects.

In particular, with the invention, a clamping system has been developed that allows to clamp any movement of a micromechanical element on a support surface of a plate made of a semiconductor material once the desired clamping position has been reached.

Furthermore, with the present invention, a clamping system has been developed that enables to obtain a higher clamping resolution of a micromechanical element along a translation axis if compared to similar known-type clamping systems.

The invention thus conceived is susceptible to numerous modifications and variations as long as they fall within the scope of the claims.

In practice, the components and materials used, as long as they are compatible with the specific use, as well as the dimensions and the contingent shapes can be anyone, according to requirements and the prior art.

If the characteristics and techniques mentioned in any claim are followed by reference signs, these reference signs are to be intended for the sole purpose of increasing the intelligibility of the claims and, consequently, such reference signs have no limiting effect on the interpretation of each element identified by way of example by these reference signs.

## Claims

1. Clamping system (10, 100) of a micromechanical element (D) defined on a support surface (12) of a plate (11) made of a semiconductor material, the clamping system comprising:
- at least one abutment element (13) projecting stably from said support surface (12) and configured to act as an end-stop for said micromechanical element (D) in a clamping position when said micromechanical element (D) is moved along a translation axis (X) towards said abutment element (13);
- a pair of fulcrum elements (14) projecting stably from said support surface (12), said fulcrum elements (14) being arranged symmetrically with respect to said translation axis (X) and being spaced along an axis orthogonal to said translation axis (X); **characterized by** further comprising
- a flexible rod (15) free to translate along said translation axis (X) on said support surface (12) and whose length at rest is greater than the minimum distance between said fulcrum elements (14), said flexible rod (15) being configured to be placed and maintained bent between said pair of fulcrum elements (14) and said micromechanical element (D) so as to clamp said micromechanical element (D) arranged in said clamping position along said translation axis (X) against said abutment element (13).

2. Clamping system (10, 100) according to claim 1, **characterised in that** each element of said pair of fulcrum elements (14) comprises a guide rod (14a), said guide rods (14a) extending in directions incident to each other in the clamping direction of said micromechanical element (D).

3. Clamping system (10, 100) according to claim 1 or 2, **characterised in that** said flexible rod (15) is fixed to said micromechanical element (D).

4. Clamping system (100) according to any one of the preceding claims, **characterised in that** it comprises at least one anchoring element (116) projecting stably from said support surface (12) and configured to mechanically engage with said micromechanical element (D) in said clamping position when said micromechanical element (D) is moved along said translation axis (X), said anchoring element (116) being configured to be welded with said micromechanical element (D) when said micromechanical element (D) is arranged in said clamping position along said translation axis (X) against said abutment element (13) and against said anchoring element (116).

5. Method for clamping a micromechanical element (D) using the clamping system (10, 100) according to claim 1, comprising
the following sequential steps:
a) arranging said flexible rod (15) at rest along said translation axis (X) between said fulcrum elements (14) orthogonally to said translation axis (X);
b) arranging said micromechanical element (D) on said support surface (12) along said translation axis (X) between said abutment element (13) and said flexible rod (15) by orienting said micromechanical element (D) to the desired clamping position;
c) translating the ends (15a, 15b) of said flexible rod (15) at the same time as said micromechanical element (D) by actuating means (17) along said translation axis (X) until passing said pair of fulcrum elements (14) and until said micromechanical element (D) is brought to rest on said abutment element (13);
d) stopping the translation of said ends (15a, 15b) of said flexible rod (15) by retracting said actuating means (17) so that said flexible rod (15), bent, rests at said ends (15a, 15b) on said pair of fulcrum elements (14) pushing said micromechanical element (D) in said clamping position along said translation axis (X) against said abutment element (13).

6. Method for clamping a micromechanical element (D) according to claim 5 by using the clamping system (100) according to claim 4, **characterised in that** it comprises the further following step:
e) applying an electrical voltage between said anchoring element (116) and said micromechanical element (D) after step d) so as to weld said anchoring element (116) to said micromechanical element (D).

## Patentansprüche

1. Spannsystem (10, 100) für ein mikromechanische Element (D), das auf einer Stützfläche (12) einer Platte (11) aus einem Halbleitermaterial definiert ist, wobei das Spannsystem Folgendes umfasst:
- mindestens ein Anschlagelement (13), das von der besagten Stützfläche (12) stabil vorsteht und dazu konfiguriert ist, als Endanschlag für das besagte mikromechanische Element (D) in einer Spannposition zu fungieren, wenn das besagte mikromechanische Element (D) entlang einer Translationsachse (X) zum besagten Anschlagelement (13) bewegt wird;
- ein Paar von Drehpunktelementen (14), die von der besagten Stützfläche (12) stabil vorstehen, wobei die besagten Drehpunktelemente (14) in Bezug auf die besagte Translationsachse (X) symmetrisch angeordnet sind und entlang einer zur besagten Translationsachse (X) orthogonalen Achse beabstandet sind;
**dadurch gekennzeichnet, dass** es ferner Folgendes umfasst:
- eine flexible Stange (15), die entlang der besagten Translationsachse (X) auf der besagten Stützfläche (12) frei verschoben werden kann und deren Länge in der Ruhestellung größer ist als der Mindestabstand zwischen den besagten Drehpunktelementen (14), wobei die besagte flexible Stange (15) so konfiguriert ist, dass sie zwischen dem besagten Paar von Drehpunktelementen (14) und dem besagten mikromechanischen Element (D) angeordnet und gebogen gehalten wird, um das besagte mikromechanische Element (D), das in der besagten Spannposition entlang der besagten Translationsachse (X) angeordnet ist, gegen das besagte Anschlagelement (13) zu spannen.

2. Spannsystem (10, 100) nach Patentanspruch 1, **dadurch gekennzeichnet, dass** jedes Element des besagten Paares von Drehpunktelementen (14) eine Führungsstange (14a) umfasst, wobei sich die besagten Führungsstangen (14a) in zueinander einfallenden Richtungen in der Spannrichtung des besagten mikromechanischen Elements (D) erstrecken.

3. Spannsystem (10, 100) nach Patentanspruch 1 oder 2, **dadurch gekennzeichnet, dass** die besagte flexible Stange (15) am besagten mikromechanischen Element (D) befestigt ist.

4. Spannsystem (100) nach jeglichem der vorhergehenden Patentansprüche, **dadurch gekennzeichnet, dass** es mindestens ein Verankerungselement (116) umfasst, das von der besagten Stützfläche (12) stabil vorsteht und konfiguriert ist, um mit dem besagten mikromechanischen Element (D) in der besagten Spannposition mechanisch in Eingriff zu treten, wenn das besagte mikromechanische Element (D) entlang der besagten Translationsachse (X) bewegt wird, wobei das besagte Verankerungselement (116) konfiguriert ist, um mit dem besagten mikromechanischen Element (D) verschweißt zu werden, wenn das besagte mikromechanische Element (D) in der besagten Spannposition entlang der besagten Translationsachse (X) gegen das besagte Anschlagelement (13) und gegen das besagte Verankerungselement (116) angeordnet ist.

5. Verfahren zum Spannen eines mikromechanischen Elements (D) unter Verwendung des Spannsystems (10, 100) nach Patentanspruch 1, die folgenden aufeinanderfolgenden Schritte umfassend:
a) Anordnen der besagten flexiblen Stange (15) in der Ruhestellung entlang der besagten Translationsachse (X) zwischen den besagten Drehpunktelementen (14) orthogonal zur besagten Translationsachse (X);
b) Anordnen des besagten mikromechanischen Elements (D) auf der besagten Stützfläche (12) entlang der besagten Translationsachse (X) zwischen dem besagten Anschlagelement (13) und der besagten flexiblen Stange (15) durch Ausrichten des besagten mikromechanischen Elements (D) in die gewünschte Spannposition;
c) Verschieben der Enden (15a, 15b) der besagten flexiblen Stange (15) gleichzeitig mit dem besagten mikromechanischen Element (D) durch Betätigungsmittel (17) entlang der besagten Translationsachse (X), bis das besagte Paar von Drehpunktelementen (14) passiert wird und bis das besagte mikromechanische Element (D) auf dem besagten Anschlagelement (13) zur Auflage gebracht wird;
d) Anhalten der Verschiebung der besagten Enden (15a, 15b) der besagten flexiblen Stange (15) durch Zurückziehen der besagten Betätigungsmittel (17), sodass die besagte flexible Stange (15), gebogen, an den besagten Enden (15a, 15b) auf dem besagten Paar von Drehpunktelementen (14) aufliegt und das besagte mikromechanische Element (D) in der besagten Spannposition entlang der besagten Translationsachse (X) gegen das besagte Anschlagelement (13) drückt.

6. Verfahren zum Spannen eines mikromechanischen Elements (D) nach Patentanspruch 5 unter Verwendung des Spannsystems (100) nach Patentanspruch 4, **dadurch gekennzeichnet, dass** es den weiteren folgenden Schritt umfasst:
e) Anlegen einer elektrischen Spannung zwischen dem besagten Verankerungselement (116) und dem besagten mikromechanischen Element (D) nach Schritt d), um das besagte Verankerungselement (116) mit dem besagten mikromechanischen Element (D) zu verschweißen.

## Revendications

1. Système de serrage (10, 100) d'un élément micromécanique (D) défini sur une surface de support (12) d'une plaque (11) en matériau semiconducteur, le système de serrage comprenant:
- au moins un élément de butée (13) faisant saillie de manière stable à partir de ladite surface de support (12) et configuré pour agir en tant que fin de course pour ledit élément micromécanique (D) dans une position de serrage lorsque ledit élément micromécanique (D) est déplacé le long d'un axe de translation (X) vers ledit élément de butée (13);
- une paire d'éléments de pivot (14) faisant saillie de manière stable à partir de ladite surface de support (12), lesdits éléments de pivot (14) étant disposés symétriquement par rapport audit axe de translation (X) et étant espacés le long d'un axe orthogonal audit axe de translation (X);
**caractérisé en ce qu'**il comprend en outre
- une tige flexible (15) libre de se déplacer le long dudit axe de translation (X) sur ladite surface de support (12) et dont la longueur au repos est supérieure à la distance minimale entre lesdits éléments de pivot (14), ladite tige flexible (15) étant configurée pour être placée et maintenue pliée entre ladite paire d'éléments de pivot (14) et ledit élément micromécanique (D) de manière à serrer ledit élément micromécanique (D) disposé dans ladite position de serrage le long dudit axe de translation (X) contre ledit élément de butée (13).

2. Système de serrage (10, 100) selon la revendication 1, **caractérisé en ce que** chaque élément de ladite paire d'éléments de pivot (14) comprend une tige de guidage (14a), lesdites tiges de guidage (14a) s'étendant dans des directions incidentes l'une par rapport à l'autre dans la direction de serrage dudit élément micromécanique (D).

3. Système de serrage (10, 100) selon la revendication 1 ou 2, **caractérisé en ce que** ladite tige flexible (15) est fixée audit élément micromécanique (D).

4. Système de serrage (100) selon l'une quelconque des revendications précédentes, **caractérisé en ce qu'il** comprend au moins un élément d'ancrage (116) faisant saillie de manière stable de ladite surface de support (12) et configuré pour s'engager mécaniquement avec ledit élément micromécanique (D) dans ladite position de serrage lorsque ledit élément micromécanique (D) est déplacé le long dudit axe de translation (X), ledit élément d'ancrage (116) étant configuré pour être soudé avec ledit élément micromécanique (D) lorsque ledit élément micromécanique (D) est disposé dans ladite position de serrage le long dudit axe de translation (X) contre ledit élément de butée (13) et contre ledit élément d'ancrage (116).

5. Procédé de serrage d'un élément micromécanique (D) à l'aide du système de serrage (10, 100) selon la revendication 1, comprenant les étapes séquentielles suivantes:
a) disposer ladite tige flexible (15) au repos le long dudit axe de translation (X) entre lesdits éléments de pivot (14) orthogonalement audit axe de translation (X);
b) disposer ledit élément micromécanique (D) sur ladite surface de support (12) le long dudit axe de translation (X) entre ledit élément de butée (13) et ladite tige flexible (15) en orientant ledit élément micromécanique (D) dans la position de serrage souhaitée;
c) déplacer les extrémités (15a, 15b) de ladite tige flexible (15) en même temps que ledit élément micromécanique (D) par des moyens d'actionnement (17) le long dudit axe de translation (X) jusqu'à passer ladite paire d'éléments de pivot (14) et jusqu'à ce que ledit élément micromécanique (D) soit amené en appui sur ledit élément de butée (13);
d) arrêter la translation desdites extrémités (15a, 15b) de ladite tige flexible (15) en rétractant lesdits moyens d'actionnement (17) de sorte que ladite tige flexible (15), pliée, s'appuie à hauteur desdites extrémités (15a, 15b) sur ladite paire d'éléments de pivot (14) poussant ledit élément micromécanique (D) dans ladite position de serrage le long dudit axe de translation (X) contre ledit élément de butée (13).

6. Procédé de serrage d'un élément micromécanique (D) selon la revendication 5 à l'aide du système de serrage (100) selon la revendication 4, **caractérisé en ce qu'il** comprend en outre l'étape suivante:
e) appliquer une tension électrique entre ledit élément d'ancrage (116) et ledit élément micromécanique (D) après l'étape d) de manière à souder ledit élément d'ancrage (116) audit élément micromécanique (D).
